(19) Europäisches Patentamt
European Patent Office
Office européen des brevets

(11) Veröffentlichungsnummer: **0 249 857**
**A2**

(12) # EUROPÄISCHE PATENTANMELDUNG

(21) Anmeldenummer: **87108324.2**

(51) Int. Cl.4: **G03C 1/68** , G03F 7/10

(22) Anmeldetag: **11.06.87**

(30) Priorität: **16.06.86 DE 3619698**

(43) Veröffentlichungstag der Anmeldung:
**23.12.87 Patentblatt 87/52**

(84) Benannte Vertragsstaaten:
**AT BE CH DE ES FR GB IT LI NL SE**

(71) Anmelder: **BASF Aktiengesellschaft**
**Carl-Bosch-Strasse 38**
**D-6700 Ludwigshafen(DE)**

(72) Erfinder: **Elzer, Albert, Dr.**
**Pappelstrasse 4**
**D-6701 Otterstadt(DE)**
Erfinder: **Sanner, Axel, Dr.**
**Lorscher Ring 2 c**
**D-6710 Frankenthal(DE)**
Erfinder: **Schupp, Hans, Dr.**
**Jean-Voelker-Strasse 40**
**D-6520 Worms 1(DE)**
Erfinder: **Beck, Erich, Dr.**
**Schweriner Weg 8**
**D-6800 Mannheim 31(DE)**

(54) **Lichtempfindliches Aufzeichnungselement.**

(57) Für die Herstellung von Druckformen oder Resistmustern geeignetes lichtempfindliches Aufzeichnungselement mit einer auf einem dimensionsstabilen Träger aufgebrachten, wäßrig-alkalisch entwickelbaren, photopolymerisierbaren Aufzeichnungsschicht, die als polymeres Bindemittel mindestens ein in Wasser unlösliches, in wäßrig-alkalischen Lösungen jedoch lösliches oder zumindest dispergierbares, filmbildendes Copolymerisat aus 10 bis 50 Gew.% mindestens eines N-Vinylamids, vorzugsweise N-Vinylcaprolactam und/oder N-Vinylpyrrolidon, 5 bis 30 Gew.% Acrylsäure und/oder Methacrylsäure, 30 bis 80 Gew.% mindestens eines Comonomeren aus der Gruppe der Vinylaromaten und (Meth)acrylsäureester von Monoalkanolen und 0,2 bis 5 Gew.% einer stickstoffbasischen olefinisch ungesättigten Verbindung mit einem $pK_a$-Wert > 4 enthält.

EP 0 249 857 A2

Xerox Copy Centre

## Lichtempfindliches Aufzeichnungselement

Die Erfindung betrifft ein lichtempfindliches Aufzeichnungselement mit einer auf einem Träger aufgebrachten, wäßrig-alkalisch entwickelbaren, ein polymeres Bindemittel enthaltenden, photopolymerisierbaren Aufzeichnungsschicht, welches insbesondere für die Herstellung von Druckformen oder Resistmustern geeignet ist.

Die bekannten, mit wäßrig-alkalischen Entwicklerlösungen auswaschbaren, lichtempfindlichen Aufzeichnungselemente für die Herstellung von photopolymeren Druckformen oder Resistmustern enthalten auf einem dimensionsstabilen Träger, z.B. einer Kunststoff-Folie oder einem Metallblech, eine photopolymerisierbare Aufzeichnungsschicht, im allgemeinen aus einer Mischung von mindestens einem in den wäßrig-alkalischen Entwicklerlösungen löslichen oder dispergierbaren polymeren Bindemittel, mindestens einer ethylenisch ungesättigten, photopolymerisierbaren, niedermolekularen Verbindung, mindestens einem Photoinitiator, sowie gegebenenfalls weiteren die verarbeitungs-und/oder anwendungstechnischen Eigenschaften verbessernden und/oder modifizierenden Zusatz-und/oder Hilfsstoffen.

Als polymere Bindemittel für die wäßrig-alkalisch entwickelbaren photopolymerisierbaren Aufzeichnungsschichten gelangen hierbei insbesondere in den wäßrig-alkalischen Entwicklerlösungsmitteln lösliche oder zumindest dispergierbare, carboxylgruppenhaltige oder Carbonsäureanhydrid-Gruppen enthaltende Copolymerisate zur Anwendung, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate oder auch Copolymerisate aus Styrol, Alkyl(meth)acrylaten und (Meth)acrylsäure sowie gegebenenfalls anderen Comonomeren (vgl. u.a. DE-B-20 27 467, SU-PS 190 211, DE-A-22 05 146, EP-A-49 504 oder DE-A 27 36 058).

Ferner ist es bereits bekannt, zur Herstellung von photopolymeren Druck-oder Reliefformen photopolymerisierbare Gemische einzusetzen, die neben photopolymerisierbaren Monomeren, mindestens einem Photoinitiator sowie gegebenenfalls weiteren Zusatz-und/oder Hilfsstoffen als polymere Bindemittel Vinylpyrrolidon-Polymerisate, wie z.B. Polyvinylpyrrolidon oder Vinylpyrrolidon/Vinylacetat-Copolymerisate, enthalten (vgl. z.B. DE-A-17 97 373). Diese photopolymerisierbaren Gemische sind mit wäßrigen Lösungsmitteln, insbesondere reinem Wasser, entwickelbar.

Die bekannten, wäßrig-entwickelbaren lichtempfindlichen Aufzeichnungsmaterialien sind wohl bereits für viele Zwecke brauchbar und geeignet, lassen jedoch hinsichtlich einer Reihe ihrer Eigenschaften noch zu wün schen übrig. So sind sie im photopolymerisierten Zustand häufig zu empfindlich gegenüber dem Auswaschmedium, d.h. die Überwaschempfindlichkeit beim Entwickeln ist groß, oder zeigen die aus ihnen hergestellten Druckformen oder Resistmuster eine unzureichende Beständigkeit gegenüber den bei ihrer Anwendung zum Einsatz gelangenden wäßrigen Medien. Feine Bildelemente sind mit diesen Aufzeichnungsmaterialien vielfach nur schwer zu reproduzieren, und es müssen bei den Auswaschbedingungen sehr enge Grenzen bezüglich Auswaschzeit, Temperatur und Zusammensetzung der Entwicklerlösung eingehalten werden. Ferner kommt es bei den bekannten, wäßrigalkalisch entwickelbaren Materialien leicht zu Restschicht-Bildungen bei der Entwicklung, d.h. die bei der bildmäßigen Belichtung nicht photopolymerisierten Anteile der Aufzeichnungsschicht lassen sich nicht restlos und einwandfrei vom Träger entfernen. Diese Erscheinung, die insbesondere beim Einsatz von metallischen Trägern oder Substraten für die photopolymerisierbare Aufzeichnungsschicht auftritt, ist vor allem bei der Herstellung von Resistmustern und Flachdruckplatten hinderlich und störend. Darüber hinaus zeigen die bisher bekannten polymeren Bindemittel für die wäßrig-alkalisch entwickelbaren photopolymerisierbaren Aufzeichnungsmaterialien nur eine begrenzte Verträglichkeit mit den üblichen, in diesen Aufzeichnungsmaterialien eingesetzten, photopolymerisierbaren Verbindungen, wodurch entweder die Einsatzbreite der photopolymerisierbaren Verbindungen beschränkt ist, oder die Belichtungseigenschaften der photopolymerisierbaren Aufzeichnungsschichten für die Praxis nicht zufriedenstellend sind.

Aus der EP 0164270 sind wasserentwickelbare, photopolymerisierbare Zusammensetzungen bekannt, die ein Copolymer aus einer $\alpha,\beta$-ethylenisch ungesättigten Carbonsäure und einem Vinylmonomeren, eine Vinylverbindung mit sekundärem oder tertiärem Stickstoffatom, eine ethylenisch ungesättigte monomere Verbindung und einen Photoinitiator enthalten. In diesen Zusammensetzungen werden also die Carboxylgruppen des Copolymeren teilweise durch die sekundären oder tertiären Stickstoffatome der monomeren Vinylverbindung neutralisiert. Derartige Zusammensetzungen lassen jedoch noch eine Reihe von Wünschen hinsichtlich Verträglichkeit und Elastizität für ihre Anwendung offen.

Aufgabe der vorliegenden Erfindung war es, neue lichtempfindliche Aufzeichnungselemente mit einer wäßrig-alkalisch entwickelbaren photopolymerisierbaren Aufzeichnungsschicht zu schaffen, die für die Herstellung von photopolymeren Druckformen oder Resistmustern geeignet sind. Insbesondere war es Aufgabe der vorliegenden Erfindung, solche lichtempfindlichen Aufzeichnungselemente zu schaffen, die sich durch eine möglichst gute Verträglichkeit des polymeren Bindemittels mit den üblicherweise eingesetzten photopolymerisierbaren Verbindungen auszeichnen, eine gute Entwickelbarkeit und einen möglichst großen Entwicklungsspielraum beim Auswaschen mit wäßrig-alkalischen Entwicklerlösungen aufweisen und gleichzeitig im belichteten Zustand eine hohe Beständigkeit gegenüber wäßrigen Medien, auch schwach alkalischen wäßrigen Lösungen, besitzen, ohne daß hierbei ihr allgemeines Eigenschaftsprofil negativ verändert wird. Die photopolymerisierbaren, wäßrig-alkalisch entwickelbaren Aufzeichnungsschichten sollen dabei insbesondere gegenüber metallischen Trägern oder Substraten eine gute Haftung aufweisen, ohne daß es jedoch bei der Verarbeitung zur Restschicht-Bildung kommt. Ganz allgemein sollen die neuen, wäßrig-alkalisch entwickelbaren lichtempfindlichen Aufzeichnungselemente gute verarbeitungs-und anwendungstechnische Eigenschaften, wie z.B. gute Belichtungseigenschaften, besitzen, die Wiedergabe auch von feinen Bildelementen exakt und sicher ermöglichen, sich für eine breite Anwendung eignen und sich für verschiedene Anwendungszwecke einfach und leicht optimal einstellen lassen.

In der deutschen Patentanmeldung P 34 47 356.4 wurde bereits ein lichtempfindliches Aufzeichnungselement vorgeschlagen, das in der photopolymerisierbaren Aufzeichnungsschicht als polymeres Bindemittel ein filmbildendes Copolymerisat aus 10 bis 50 Gew.% eines Vinylamids, 5 bis 30 Gew.% (Meth)acrylsäure und 30 bis 80 Gew.% eines hydrophoben Comonomeren enthält.

Bei der Resist-Herstellung wird auf automatischen Laminatoren die Polyethylen-Schutzfolie abgezogen und der Verbund Polyester-Trägerfolie/Resistfilm mit einem Schneidmesser zu einem Format geschnitten. Infolge der Sprödigkeit des unbelichteten Resists flittern bei diesem Vorgang Teile des Resists an der Schnittkante von der Polyester-Folie ab. Die Anwender fordern außerdem die Korrigierbarkeit des entwickelten Resists; so werden z.B. "Nasen" auf einer Platte, die in einen entwickelten Bereich hineinragen (z.B. aufgrund eines fehlerhaften Negativs), mit einem Skalpell abgeschnitten bzw. korrigiert. Dabei dürfen keine Teile aus dem zu schützenden Bereich ausbrechen. Auch der belichtete Resist muß möglichst elastisch sein.

Nach dem Stand der Technik kann eine Erhöhung der Elastizität dadurch erreicht werden, daß man in das photopolymerisierbare Material Weichmacher einarbeitet. Dies ist jedoch nicht völlig zufriedenstellend, da solche Weichmacher dazu neigen, bei der Alterung in den Film zu wandern und stark zum Kaltfließen beitragen. Kaltfließen kann jedoch nicht toleriert werden, da die Filmrollen unter statischer Belastung gelagert werden und nach kurzer Zeit das photopolymerisierbare Material beginnt, zwischen den Schichten herauszusickern. Danach verschmilzt das Material nach dem Heraussickern entlang der Kante der Rollen und macht es schwie rig, wenn nicht sogar unmöglich, das Material gleichmäßig und ohne Zerstörung des zusammengesetzten Filmes abzurollen. Außerdem sind viele Weichmacher flüchtig. Während der Herstellung des Filmes verdampft etwas von dem Weichmacher, wenn das Trocknen nicht genau kontrolliert wird, wobei der Film in seinen spröden Zustand zurückgeführt wird.

Es sollten also Elastizität und Verträglichkeit des polymeren Bindemittels mit Oligomeren verbessert und der kalte Fluß des Aufzeichnungselements auf der Rolle verringert werden.

Es wurde nun überraschenderweise gefunden, daß diese Aufgabe durch lichtempfindliche Aufzeichnungselemente mit einer auf einem dimensionsstabilen Träger aufgebrachten, wäßrig-alkalisch entwickelbaren, photopolymerisierbaren Aufzeichnungsschicht gelöst wird, wenn die photopolymerisierbare Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat enthält, welches aus 10 bis 50 Gew.% mindestens eines N-Vinylamids, 5 bis 30 Gew.% an Acrylsäure und/oder Methacrylsäure sowie 30 bis 80 Gew.% mindestens eines Comonomeren aus der Gruppe der Vinylaromaten und Ester der (Meth)acrylsäure mit $C_1$-bis $C_8$-Monoalkanolen und 0,2 bis 5 Gew.% einer copolymerisierbaren, stickstoffbasischen, olefinisch ungesättigten organischen Verbindung, die einen $pK_a$-Wert von größer als 4 aufweist, besteht.

Gegenstand der Erfindung ist dementsprechend ein zur Herstellung von photopolymeren Druckformen oder Resistmustern geeignetes, lichtempfindliches Aufzeichnungselement mit einer auf einem dimensionsstabilen Träger aufgebrachten, wäßrig-alkalisch entwickelbaren, ein polymeres Bindemittel enthaltenden photopolymerisierbaren Aufzeichnungsschicht, welches dadurch gekennzeichnet ist, daß in der photopolymerisierbaren Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat aus 10 bis 50 Gew.% mindestens eines N-Vinylamids, 5 bis 30 Gew.% Acrylsäure und/oder Methacrylsäure

sowie 30 bis 80 Gew.% mindestens eines Comonomeren aus der Gruppe der Vinylaromaten und Ester der Acrylsäure oder Methacrylsäure mit 1 bis 8 Kohlenstoffatome enthaltenden Monoalkanolen und 0,2 bis 5 Gew.% mindestens einer copolymerisierbaren, stickstoffbasischen, olefinisch ungesättigten organischen Verbindung mit einem $pK_a$-Wert > 4 enthalten ist.

Als copolymerisierbare, stickstoffbasische, olefinisch ungesättigte organische Verbindungen mit $pK_a$-Werten > 4 bevorzugt sind Verbindungen der allgemeinen Formeln

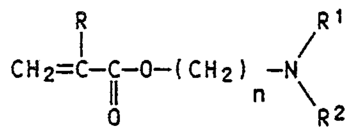

(I)

und/oder

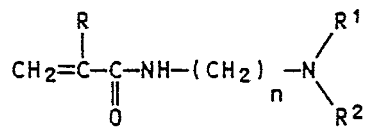

(II)

worin n = 2 bis 6, R für Wasserstoff oder eine Methylgruppe steht, $R^1$ und $R^2$ untereinander gleich oder verschieden sind und für Wasserstoff, einen geradkettigen oder verzweigten Alkylrest mit 1 bis 6 Kohlenstoffatomen, einen geradkettigen oder verzweigten Hydroxyalkylrest mit 1 bis 6 Kohlenstoffatomen, einen geradkettigen oder verzweigten Hydroxyalkylrest mit 1 bis 6 Kohlenstoffatomen, dessen Hydroxygruppen mit 1 bis 4 Kohlenstoffatome enthaltenden Alkanolen verethert sind, einen Cycloalkylrest mit 5 oder 6 Kohlenstoffatomen stehen oder die Reste $R^1$ und $R^2$ zusammen einen fünf-oder sechsgliedrigen Ring bilden, der gegebenenfalls ein weiteres Heteroatom enthält, sowie auch N-Vinylimidazol und 2-Methyl-1-vinylimidazol.

Durch den erfindungsgemäßen Einsatz der speziellen Copolymerisate als polymeres Bindemittel in den photopolymerisierbaren Aufzeichnungsschichten werden lichtempfindliche Aufzeichnungselemente mit sehr vorteilhaften Eigenschaften erhalten. Das erfindungsgemäß einzusetzende Copolymerisat ist beispielsweise bei K-Werten (nach Fikentscher) zwischen 32 und 36 in dem für die Anwendung interessanten Konzentrationsbereich mit polymerisierbaren Oligomeren gut verträglich. Durch die verbesserte Verträglichkeit der erfindungsgemäß einzusetzenden Copolymerisate mit photopolymerisierbaren Monomeren und Oligomeren läßt sich in den photopolymerisierbaren Aufzeichnungsschichten eine breite Vielfalt solcher auch mehrfunktioneller, photopolymerisierbarer Monomere und/oder Oligomere selbst in großen Mengen einsetzen. Dadurch läßt sich das Eigenschaftsbild der mit den erfindungsgemäßen Aufzeichnungselementen hergestellten Druckformen oder Resistmuster einfach und leicht variieren. Trotz einer guten Entwickelbarkeit in rein wäßrig-alkalischen Entwicklerlösungen zeigen die Aufzeichnungsmaterialien im photopolymerisierten Zustand eine hohe Beständigkeit gegenüber wäßrigen Medien, wie sie beispielsweise bei der Verwendung von Druckformen und insbesondere auch bei Einsatz von Resistmustern in der Ätz-oder Galvanotechnik zur Anwendung kommen. Die erfindungsgemäßen lichtempfindlichen Aufzeichnungselemente zeigen eine geringe Überwaschempfindlichkeit, die photopolymerisierbare Aufzeichnungsschicht ist auch auf metallischen Trägern oder Substraten stabil bei gleichzeitig guter Haftung zu diesen Trägern bzw. Substraten, und sie erlauben die exakte und sichere Reproduktion auch von feinen Bildelementen, beispielsweise Linien von 100µm Breite oder darunter. Die lichtempfindlichen Aufzeichnungselemente können wegen der guten Haftungsdifferenzierung der erfindungsgemäßen photopolymerisierbaren Aufzeichnungsschichten auch mit Vorteil als Trockenfilmresist für die trockene Schichtübertragung eingesetzt werden.

Bei den erfindungsgemäß in der photopolymerisierbaren Aufzeichnungsschicht der lichtempfindlichen Aufzeichnungselemente enthaltenen polymeren Bindemitteln handelt es sich um Copolymerisate, die in reinem Wasser unlöslich, in wäßrig-alkalischen Lösungen jedoch löslich oder zumindest dispergierbar sind. Bevorzugt sind die erfindungsgemäß modifizierten N-Vinylamid-Copolymerisate in wäßrig-alkalischen Lösungen mit einem pH-Wert größer als etwa 9, insbesondere im Bereich von etwa 9 bis 13, löslich oder zumindest dispergierbar, in wäßrig-alkalischen Lösungen mit pH-Werten unter etwa 9 jedoch unlöslich. Die erfindungsgemäß einzusetzenden Copolymerisate sollen darüberhinaus filmbildend sein und haben im allgemeinen ein mittleres Molekulargewicht (Gewichtsmittel) größer etwa 10.000, vorzugsweise im Bereich von etwa 15.000 bis etwa 500.000, insbesondere im Bereich von etwa 20.000 bis 250.000.

Die erfindungsgemäß einzusetzenden Copolymerisate sind aufgebaut aus vier verschiedenen Arten von Comonomeren, nämlich (a) N-Vinylamiden, (b) Acryl-und/oder Methacrylsäure, (c) Vinylaromaten und/oder (Meth)acrylsäureestern von Monoalkanolen und (d) copolymerisierbaren stickstoffbasischen, olefinisch ungesättigten Verbindungen mit einem $pK_a$-Wert > 4. Als vorteilhaft haben sich unter den Estern der (Meth)-acrylsäure mit Monoalkanolen diejenigen erwiesen, die als solche Homopolymerisate mit einer Glasübergangstemperatur (gemessen nach der DSC-Methode) über 300°K, insbesondere über 320°K, zu bilden vermögen. Die Comonomeren für die Herstellung der erfindungsgemäß einzusetzenden Copolymerisate sollen selbstverständlich miteinander copolymerisierbar sein.

Das erfindungsgemäß als polymeres Bindemittel einzusetzende Copolymerisat enthält (a) 10 bis 50 Gew.% mindestens eines N-Vinylamids, (b) 5 bis 30 Gew.% Acrylsäure und/oder Methacrylsäure, (c) 30 bis 80 Gew.% mindestens eines Comonomeren aus der Gruppe der Vinylaromaten und Ester der Acrylsäure oder Methacrylsäure mit 1 bis 8 Kohlenstoffatome enthaltenden Monoalkanolen und (d) 0,2 bis 5 Gew.% mindestens einer copolymerisierbaren stickstoffbasischen olefinisch ungesättigten organischen Verbindung mit einem $pK_a$-Wert > 4 einpolymerisiert, wobei die Summe der unter (a) bis (d) genannten Prozentzahlen 100 ist.

Als N-Vinylamide kommen beispielsweise die N-Vinyl-Derivate von aliphatischen Carbonsäureamiden in Betracht, wie z.B. N-Vinylformamid, N-Vinylacetamid oder N-Vinyl-N-Methylacetamid. Bevorzugt enthalten die erfindungsgemäß einzusetzenden Copolymerisate als N-Vinylamid-Comonomere N-Vinyllactame, insbesondere N-Vinylpyrrolidon und/oder N-Vinylcaprolactam, einpolymerisiert. Die Copolymerisate können ein oder mehrere der N-Vinylamid-Comonomeren einpolymerisiert enthalten, wobei der Anteil der in dem Copolymerisat einpolymerisierten N-Vinylamid-Comonomereinheiten im Bereich von 10 bis 50 Gew.%, vorzugsweise im Bereich von 20 bis 45 Gew.%, bezogen auf das Copolymerisat, liegt.

Als zweite Gruppe von Comonomeren enthält das erfindungsgemäß einzusetzende Copolymerisat Acrylsäure und/oder Methacrylsäure in einer Menge von 5 bis 30 Gew.%, insbesondere in einer Menge von 5 bis 15 Gew.%, bezogen auf das Copolymerisat, einpolymerisiert.

Als Beispiele für die Comonomeren, die in dem erfindungsgemäß einzusetzenden Copolymerisat als dritter Bestandteil einpolymerisiert enthalten sind, seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol und p-Methylstyrol, die Ester der Acrylsäure und Methacrylsäure mit $C_1$-bis $C_8$-Monoalkanolen, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere dieser Vinylaromaten und/oder (Meth)-acrylester einpolymerisiert enthalten, wobei ihr Anteil in dem Copolymerisat 30 bis 80 Gew.%, vorzugsweise 40 bis 70 Gew.%, bezogen auf das Copolymerisat, beträgt.

Als vierte Gruppe von Comonomeren enthält das erfindungsgemäß einzusetzende Copolymerisat mindestens eine copolymerisierbare, stickstoffbasische, olefinisch ungesättigte organische Verbindung mit einem $pK_a$-Wert > 4 einpolymerisiert. Als solche Verbindungen kommen vorzugsweise Verbindungen der allgemeinen Formeln

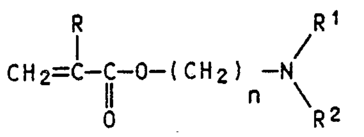

(I)

und/oder

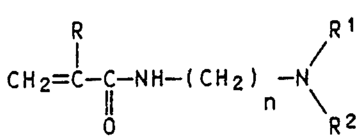

(II)

in Frage, worin n = 2 bis 6, R für Wasserstoff oder eine Methylgruppe steht, $R^1$ und $R^2$ untereinander gleich oder verschieden sind und für Wasserstoff, einen geradkettigen oder verzweigten Alkylrest mit 1 bis 6 Kohlenstoffatomen, einen geradkettigen oder verzweigten Hydroxyalkylrest mit 1 bis 6 Kohlenstoffatomen, einen geradkettigen oder verzweigten Hydroxyalkylrest mit 1 bis 6 Kohlenstoffatomen, dessen Hydroxygruppen mit 1 bis 4 Kohlenstoffatome enthaltenden Alkanolen verethert sind, einen Cycloalkylrest mit 5 oder 6 Kohlenstoffatomen stehen oder die Reste $R^1$ und $R^2$ zusammen einen fünf-oder sechsgliedrigen Ring bilden, der gegebenenfalls ein weiteres Heteroatom enthält, sowie N-Vinylimidazol und 2-Methyl-1-vinylimidazol.

Bevorzugt sind besonders Dialkylaminoalkyl(meth)acrylate und Dialkylamino(meth)acrylamide der allgemeinen Formeln (I) und/oder (II), worin n = 2 bis 6 und $R^1$ und $R^2$ geradkettige Alkylreste mit 1 bis 4 Kohlenstoffatomen bedeuten, wie z.B. Dimethylaminoethylacrylat, Dimethylaminoethylmethacrylat, Diethylaminoethylmethacrylat, Diethylaminoethylacrylat, Diethylaminoethylacrylamid, Dimethylaminoethylacrylamid, Diethylaminoethylmethacrylamid und Dimethylaminoethylmethacrylamid. Der Anteil der stickstoffbasischen olefinisch ungesättigten Comonomeren im Copolymerisat beträgt 0,2 bis 5, vorzugsweise 1,5 bis 2,5 Gew.%, bezogen auf das Copolymerisat.

Beispiele für Copolymerisate, die sich für den erfindungsgemäßen Einsatz als polymeres Bindemittel in den photopolymerisierbaren Aufzeichnungsschichten der lichtempfindlichen Aufzeichnungselemente als besonders vorteilhaft erwiesen haben, sind u.a. N-Vinyllactam/(Meth)-acrylsäure/Methylmethacrylat/Dimethylaminoethyl(meth)acrylat-Copolymerisate oder N-Vinyllactam/(Meth)-acrylsäure/Styrol/Dimethylaminoethyl(meth)acrylat-Copolymerisate. In einer typischen Ausführungsform enthalten diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an Methylmethacrylat und 1,5 bis 2,5 Gew.% Dimethylaminoethyl(meth)acrylat, jeweils bezogen auf das Copolymerisat, einpolymerisiert.

Die Comonomeren für die erfindungsgemäß einzusetzenden Copolymerisate werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Die Grenzen für den Anteil der einzelnen Comonomer-Gruppen sind dabei im Hinblick auf die allgemeinen Eigenschaften der Copolymerisate und speziell der hiermit hergestellten erfindungsgemäßen lichtempfindlichen Aufzeichnungselemente von Bedeutung. Liegt der Gehalt der einzelnen Comonomeren in den Copolymerisaten außerhalb dieser Grenzen, so werden die Eigenschaften der erfindungsgemäßen lichtempfindlichen Aufzeichnungselemente bzw. die der hieraus hergestellten Druckformen oder Resistmuster nachteilig beeinflußt.

Die erfindungsgemäß als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen, in Betracht.

In der photopolymerisierbaren Aufzeichnungsschicht der erfindungsgemäßen lichtempfindlichen Aufzeichnungselemente können ein oder mehrere modifizierte N-Vinylamid-Copolymerisate der in Rede stehenden Art als polymeres Bindemittel enthalten sein. Neben dem polymeren Bindemittel enthält die photopolymerisierbare Aufzeichnungsschicht im allgemeinen mindestens eine ethylenisch ungesättigte, photopolymerisierbare Verbindung, mindestens einen Photopolymerisationsinitiator bzw. ein Photopolymerisationsinitiatorsystem sowie gegebenenfalls weitere Zusatz-und/oder Hilfsstoffe zur Verbesserung und/oder Modifizierung der allgemeinen Eigenschaften der lichtempfindlichen Aufzeichnungselemente bzw. der hieraus hergestellten Druckformen oder Resistmuster.

Als ethylenisch ungesättigte, photopolymerisierbare Verbindungen kommen dabei sowohl Monomere als auch ethylenisch ungesättigte, photopolymerisierbare Oligomere in Betracht. Die Monomeren haben im allgemeinen ein Molekulargewicht unter 1.000. Das mittlere Molekulargewicht (Zahlenmittel) der photopolymerisierbaren Oligomeren liegt vorzugsweise im Bereich von etwa 1.000 bis 10.000, insbesondere von etwa 1.500 bis 6.000. Die photopolymerisierbaren Monomeren und Oligomeren können dabei sowohl mono-als auch polyfunktionell sein, d.h. eine oder mehrere photopolymerisierbare, ethylenische Doppelbindungen besitzen. Üblicherweise sind in der photopolymerisierbaren Aufzeichnungsschicht bi-oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten. Wegen der guten Verträglichkeit der erfindungsgemäß als polymeres Bindemittel einzusetzenden speziellen N-Vinylamid-Copolymerisate kommen als photopolymerisierbare Verbindungen in den erfindungsgemäßen lichtempfindlichen Aufzeichnungselementen eine große Vielzahl von Mono meren und Oligomeren in Betracht, die allein oder in Mischung miteinander eingesetzt werden können.

Als Vertreter für die photopolymerisierbaren Monomeren seien insbesondere die Derivate der (Meth)-acrylsäure und ganz besonders die (Meth)acrylsäureester genannt. Beispiele hierfür sind die Di-und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra-(meth)acrylat, Glucosetri-oder tetra-(meth)acrylat, ferner die Monoacrylate und Monomethacrylate der genannten Diole und Polyole, wie z.B. Ethylenglykol-, Di-, Tri-oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure, Glyoxalbisamid und andere.

Sehr geeignete ethylenisch ungesättigte, photopolymerisierbare Verbindungen für die erfindungsgemäßen lichtempfindlichen Aufzeichnungselemente sind auch die monomeren Urethanacrylate bzw. -methacrylate mit zwei oder mehr Acryloyl-und/oder Methacryloyl-Gruppen. Solche monomeren Urethan-(meth)acrylate können beispielsweise erhalten werden durch Umsetzung von aliphatischen Di-oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl-und/oder Methacryloyl-Verbindungen, beispielsweise Hydroxyalkyl-(meth)acrylaten. Als aliphatische Di-oder Polyole kommen unter anderem die vorstehend im Zusammenhang mit den Di-und Tri(meth)acrylaten genannten Di-und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl-(meth)acrylate sind beispielsweise Hydroxyethyl-(meth)acrylat, Propandiol-mono(meth)acrylat oder Butandiol-mono(meth)acrylat. Ebenso geeignet und vorteilhaft sind Monomere mit zwei oder mehr Acryloyl-und/oder Methacryloyl-Gruppen, wie sie beispielsweise erhalten werden können durch Umsetzung von Di-oder Polyglycidylverbindungen mit Acrylsäure und/oder Methacrylsäure. Als Di-und Polyglycidylverbindungen kommen hier insbesondere die Di-und Polyglycidylether mehrwertiger Phenole, beispielsweise des Bisphenols A oder der Substitutionsprodukte von Bisphenol A, in Betracht. Beispielhaft für solche Acryloyl-und/oder Methacryloyl-Gruppen enthaltenden Monomeren seien die Umsetzungsprodukte des Bisphenol A-bisglycidylethers mit Acryl-und/oder Methacrylsäure im molaren Verhältnis von etwa 1:2 hervorgehoben.

Als besonders vorteilhaft, insbesondere für die Herstellung von Resistmustern, hat es sich erwiesen, wenn die lichtempfindlichen Aufzeichnungselemente in der photopolymerisierbaren Aufzeichnungsschicht als photopolymerisierbare Verbindung Oligomere mit 2 oder vorzugsweise mehr als 2 Acryloyl-und/oder Methacryloyl-Gruppen enthalten. Hierbei kann es sich beispielsweise um Acryloyl-und/oder Methacryloyl-Gruppen enthaltende oligomere Urethan-Harze oder um solche auf Basis von Di-oder Polyepoxiden handeln, wie sie als solche bekannt und in der Literatur beschrieben sind. Von besonderem Interesse sind hierbei solche Oligomeren der in Rede stehenden Art, die neben den Acryloyl-und/oder Methacryloyl-Gruppen zusätzlich noch freie Carboxylgruppen im Molekül enthalten. Der Anteil der freien Carboxyl-Gruppen in diesen photopolymerisierbaren Oligomeren liegt dabei vorteilhafterweise so hoch, daß die Oligomeren eine Säurezahl im Bereich von 50 bis 150 mg KOH/g aufweisen. Geeignete photopolymerisierbare Oligomere dieser Art, wie sie auch in den erfindungsgemäßen lichtempfindlichen Aufzeichnungselementen enthalten sein können, sind z.B. in der DE-A-24 42 527, der DE-C-25 57 408 oder auch der DE-A-29 17 483 beschrieben. Weitere photopolymerisierbare Oligomere, deren Einsatz in den erfindungsgemäßen lichtempfindlichen Aufzeichnungselementen zu besonders günstigen Ergebnissen geführt hat, können beispielsweise hergestellt werden, indem man die Hydroxylgruppen einer Acryloyl-und/oder Methacryloyl-Gruppen enthaltenden Diol-oder Polyol-Verbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsprodukts unter Kettenverlängerung sowie gegebenenfalls Verzweigung mit Di-und/oder Polyepoxiden umsetzt. Die Acryloyl-und/oder Methacryloyl-Gruppen enthaltenden Diol-oder Polyol-Verbindungen, die als Ausgangsprodukt für die Herstellung solcher Oligomeren dienen, werden zweckmäßigerweise hergestellt, indem man Di-oder Polyepoxid-Verbindungen, wie z.B. Di-oder Polyglycidylether bzw. Di-oder Polyglycidylester mit Acrylsäure und/oder Methacrylsäure im Äquivalentverhältnis Glycidyl-Gruppen:COOH-Gruppen von etwa 1:1 umsetzt. Die Di-oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bisglycidylether mit Acryl-und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl-und/oder Methacrylsäure im Äquivalentverhältnis Glycidyl-Gruppen:Gesamt-COOH von etwa 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in

Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von etwa 1:1 unter Bildung der sauren Teilester der mehrfachen Carbonsäuren und schließlich Umsetzung eines Teils der freien Carboxyl-Guppen des so erhaltenen Reaktionsproduktes mit einem Di-und/oder Polyglycidylether, beispielsweise Bisphenol A-bisglycidylether oder Pentaerythrittriglycidylether, im Äquivalentverhältnis COOH-Gruppen:Glycidyl-Gruppen von größer 1:1, vorzugsweise im Bereich von etwa 1,15:1 bis 5:1.

Die ethylenisch ungesättigten, photopolymerisierbaren Monomeren und/oder Oligomeren werden dabei so gewählt, daß sie mit den als polymerem Bindemittel eingesetzten modifizierten N-Vinylamid-Copolymerisaten verträglich sind. Das Mengenverhältnis von polymerem Bindemittel zu den ethylenisch ungesättigten, photopolymerisierbaren Verbindungen in der photopolymerisierbaren Aufzeichnungsschicht der erfindungsgemäßen lichtempfindlichen Aufzeichnungselemente kann in weiten Grenzen variiert werden und beispielsweise im Bereich von 1:99 bis 90:10 liegen. Ein niedriger Anteil an polymerem Bindemittel, beispielsweise im Bereich von etwa 1 bis 35 Gew.%, bezogen auf die photopolymerisierbare Aufzeichnungsschicht, kommt insbesondere dann in Betracht, wenn in der photopolymerisierbaren Aufzeichnungsschicht als ethylenisch ungesättigte, photopolymerisierbare Verbindung ein hoher Anteil, beispielsweise 40 Gew.% oder mehr und insbesondere mehr als etwa 45 Gew.%, bezogen auf die photopolymerisierbare Aufzeichnungsschicht, an einem oder mehreren, mehr als zwei Acryloyl-und/oder Methacryloyl-Gruppen sowie freie Carboxyl-Gruppen enthaltenden Oligomeren enthalten ist.

Als Photoinitiatoren für die photopolymerisierbaren Aufzeichnungsschichten kommen die für lichtempfindliche, photopolymerisierbare Aufzeichnungsmaterialien üblichen und an sich bekannten Photoinitiatoren bzw. Photoinitiatorsysteme in Betracht. Beispielhaft seien hierfür genannt: Benzoin, Benzoinether, insbesondere Benzoinalkylether, substituierte Benzoine, Alkylether von substituierten Benzoinen, wie z.B. α-Methylbenzoinalkylether oder α-Hydroxymethylbenzoinalkylether; Benzile, Benzilketale, insbesondere Benzildimethylketal, Benzilmethylethylketal oder Benzilmethylbenzylketal; die als Photoinitiator bekannten und wirksamen Acylphosphinoxid-Verbindungen, wie z.B. 2,4,6-Trimethylbenzoyldiaryl phosphinoxid; Benzophenon, Derivate des Benzophenons, 4,4'-Dimethylaminobenzophenon, 4,4'-Diethylaminobenzophenon, Derivate von Michler's Keton; Anthrachinon und substituierte Anthrachinone; arylsubstituierte Imidazole oder deren Derivate, wie z.B. 2,4,5-Triarylimidazoldimere; 2-Chlorthioxanthon und die als Photoinitiatoren wirksamen Acridin-oder Phenacin-Derivate. Beispiele für Initiatorsysteme sind Kombinationen der genannten Initiatoren mit Sensibilisierungshilfsmitteln oder Aktivatoren, wie insbesondere tertiären Aminen. Typische Beispiele für solche Initiatorsysteme sind Kombinationen aus Benzophenon oder Benzophenon-Derivaten mit tertiären Aminen, wie Triethanolamin oder Michler's Keton; oder Gemische aus 2,4,5-Triarylimidazol-Dimeren und 2-Mercaptobenzochinazol oder den Leukobasen von Triphenylmethanfarbstoffen. Die Auswahl der geeigneten Photoinitiatoren bzw. Photoinitiator-Systeme ist dem Fachmann geläufig. Die Photoinitiatoren bzw. Photoinitiatorsysteme sind in der photopolymerisierbaren Aufzeichnungsschicht im allgemeinen in Mengen von 0,001 bis 10 Gew.%, vorzugsweise in Mengen von 0,05 bis 5 Gew.%, bezogen auf die photopolymerisierbare Aufzeichnungsschicht, enthalten.

Als weitere Zusatz-und/oder Hilfsstoffe, die in der photopolymerisierbaren Aufzeichnungsschicht der erfindungsgemäßen lichtempfindlichen Aufzeichnungselemente enthalten sein können, kommen z.B. thermische Polymerisationsinhibitoren, Farbstoffe und/oder Pigmente, photochrome Verbindungen bzw. Systeme, sensitometrische Regler, Weichmacher, Verlaufshilfsmittel, Mattierungs-oder Gleitmittel und dergleichen in Betracht. Geeignete thermische Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe, Azosole und 3'-Phenyl-7-dimethylamino-2,2'-spiro-di-(2H-1-benzopyran). Photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren. Als Beispiele für Leukofarbstoffe seien die Leukobasen der Triphenylmethanfarbstoffe, wie Kristallviolett-Leukobase und Malachitgrün-Leukobase, Leuko-Basischblau, Leuko-Pararosanilin, Leuko-Patentblau A oder V genannt; ferner kommt auch Rhodamin B-Base in Betracht. Als Aktivatoren für diese photochromen Verbindungen kommen u.a. organische Halogenverbindungen, die bei Belichtung mit aktinischem Licht Halogenradikale abspalten, oder Hexaarylbisimidazole in Betracht. Zu den sensitometrischen Reglern gehören Verbindungen wie z.B. 9-Nitroanthracen, 10,10'-Bisanthron, Phenazinium-, Phenoxazinium-, Acridinium-oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate,

Toluolsulfonamid oder Tricresylphosphat, dienen. Die Zusatz-und/oder Hilfsstoffe sind in den photopolymerisierbaren Aufzeichnungsschichten in den für diese Stoffe üblichen und bekannten wirksamen Mengen vorhanden. Ihre Menge sollte jedoch im allgemeinen 30 Gew.%, vorzugsweise 20 Gew.%, bezogen auf die photopolymerisierbare Aufzeichnungsschicht, nicht überschreiten.

Das Mischungsverhältnis, in dem die einzelnen Komponenten in der photopolymerisierbaren Aufzeichnungsschicht enthalten sind, wird im allgemeinen so gewählt, daß diese Aufzeichnungsschicht nicht nur wäßrig-alkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Aufzeichnungselemente als Photoresistfilm wird die Zusammensetzung darüber hinaus so gewählt, daß die photopolymerisierbare Aufzeichnungsschicht gut laminierbar und unter Anwendung von Druck sowie gegebenenfalls Wärme auf ein Substrat übertragbar ist. Die Dicke der photopolymerisierbaren Aufzeichnungsschicht richtet sich bekanntermaßen nach dem Anwendungszweck der lichtempfindlichen Aufzeichnungselemente und kann daher in weiten Grenzen schwanken. Für die Herstellung von Hochdruck- oder Tiefdruckformen liegt die Dicke der photopolymerisierbaren Aufzeichnungsschicht im allgemeinen im Bereich von etwa 100 $\mu m$ bis einigen mm; für die Herstellung von Resistmustern werden üblicherweise Schichtdicken der photopolymerisierbaren Aufzeichnungsschicht im Bereich von etwa 1 bis 50 $\mu m$ eingestellt; für Flachdruckplatten liegt die Dicke der photopolymerisierbaren Aufzeichnungsschicht im allgemeinen im Bereich von etwa 0,5 bis 6 $\mu m$.

In einer typischen Ausführungsform der Erfindung besteht die photopolymerisierbare Aufzeichnungsschicht der lichtempfindlichen Aufzeichnungselemente aus einer homogenen, filmbildenden und in wäßrig-alkalischen Lösungen löslichen oder zumindest dispergierbaren Mischung von

a) 40 bis 90 Gew.% mindestens eines erfindungsgemäß modifizierten N-Vinylamid-Copolymerisats der vorstehend genannten Art als polymerem Bindemittel,

b) 8 bis 55 Gew.% mindestens eines ethylenisch ungesättigten, photopolymerisierbaren, mit dem bzw. den polymeren Bindemitteln verträglichen Monomeren, bei hohen Monomer-Gehalten gegebenenfalls auch in Mischung zusammen mit einer untergeordneten Menge an einem oder mehreren, verträglichen, photopolymerisierbaren Oligomeren,

c) 0,001 bis 10 Gew.% mindestens eines Photopolymerisationsinitiators sowie

d) 0 bis 30 Gew.%, vorzugsweise 0,05 bis 20 Gew.%, an weiteren, die allgemeinen Eigenschaften der Aufzeichnungselemente bzw. der hieraus hergestellten Druckformen oder Resistmuster verbessernden bzw. modifizierenden Zusatz-und/oder Hilfsstoffen.

Wie vorstehend bereits erwähnt wurde, können die photopolymerisierbaren Aufzeichnungsschichten jedoch auch weniger als 40 Gew.%, beispielsweise nur 1 bis etwa 35 Gew.%, bezogen auf die photopolymerisierbare Aufzeichnungsschicht, des oder der polymeren Bindemittel enthalten. In diesem Fall enthält die photopolymerisierbare Aufzeichnungsschicht, neben Photoinitiator sowie gegebenenfalls weiteren Zusatz-und/oder Hilfsstoffen, mindestens 40 Gew.%, vorzugsweise 45 bis 75 Gew.%, bezogen auf die photopolymerisierbare Aufzeichnungsschicht, an einem oder mehreren, in wäßrig-alkalischen Lösungen löslichen oder zumindest dispergierbaren Oligomeren mit mehr als zwei ethylenischen, photopolymerisierbaren Doppelbindungen, insbesondere Acryloyl-und/oder Methacryloyl-Gruppen, sowie vorzugsweise freien Carboxyl-Gruppen und mit einem mittleren Molekulargewicht (Zahlenmittel) im Bereich von etwa 1000 bis 10.000. Neben den photopolymerisierbaren Oligomeren kann die photopolymerisierbare Aufzeichnungsschicht in diesen Fällen auch noch photopolymerisierbare Monomere, insbesondere in einer Menge von etwa 1 bis 30 Gew.%, vorzugsweise von etwa 10 bis 25 Gew.%, bezogen auf die photopolymerisierbare Aufzeichnungsschicht, enthalten. Solche photopolymerisierbaren Aufzeichnungsschichten mit einem sehr geringen Anteil an polymerem Bindemittel eignen sich insbesondere für dünne Schichten, wie sie beispielsweise bei der Herstellung von Resistmustern und Photoresistfilmen zur Anwendung kommen.

Als Träger für die photopolymerisierbaren Aufzeichnungsschichten kommen die für lichtempfindliche Aufzeichnungselemente der in Rede stehenden Art üblichen und an sich bekannten dimensionsstabilen, starren oder vorzugsweise flexiblen Schichtträger in Betracht, wobei die Art des Schichtträgers vom Verwendungszweck der lichtempfindlichen Aufzeichnungselemente mitbestimmt wird. So kommen für die Herstellung von Druckplatten als dimensionsstabile Träger insbesondere Kunststoff-Filme oder -Folien, z.B. aus Polyestern, sowie metallische Schichtträger, beispielsweise aus Stahl oder Aluminium, in Betracht. Für Photoresistfilme und Schichtübertragungsmaterialien finden als Trägermaterialien vorzugsweise Kunststoff-Filme oder -Folien, insbesondere Polyester-Folien, Verwendung, die eine mäßige Haftung zu der photopolymerisierbaren Aufzeichnungsschicht haben und nach dem Auflaminieren bzw. Aufkaschieren der photopolymerisierbaren Aufzeichnungsschicht auf ein Substrat von dieser - vor oder nach der Belichtung mit aktinischem Licht - abgezogen werden können. Für die Herstellung von Resistmustern kann die photopolymerisierbare Aufzeichnungsschicht auch direkt auf das zu schützende sowie gegebenenfalls dauerhaft zu

modifizierende Substrat aufgebracht werden, welches dann als Täger für die photopolymerisierbare Aufzeichnungsschicht fungiert. Als Substrate für Photoresistschichten kommen beispielsweise Kupferbleche, kupferkaschierte Basismaterialien, Keramiksubstrate, die mit metallischen oder metalloxidischen Schichten beschichtet sind, Halbleiterelemente, Silicium-Wafer und dergleichen in Betracht. Die Trägermaterialien für die photopolymerisierbaren Aufzeichnungsschichten können gegebenenfalls in an sich bekannter Weise, z.B. mechanisch, chemisch, elektrochemisch und/oder durch Versehen mit einer Haftgrundierung, vorbehandelt sein. Gleichermaßen können zwischen photopolymerisierbarer Aufzeichnungsschicht und Träger auch noch eine oder mehrere Zwischenschichten angeordnet sein. Bei lichtempfindlichen Aufzeichnungselementen für die Herstellung von Druckformen, insbesondere Hochdruck-oder Tiefdruckformen, können diese Zwischenschichten als Haftschicht und/oder Lichthofschutzschicht ausgebildet sein. Bei Photoresistfilmen und Schichtübertragungsmaterialien kann eine solche Zwischenschicht zwischen photopolymerisierbarer Aufzeichnungsschicht und dem abziehbaren, temporären Schichtträger das Abziehen des Schichtträgers nach dem Auflaminieren bzw. Aufkaschieren der photopolymerisierbaren Aufzeichnungsschicht auf das Substrat erleichtern und/oder als Sauerstoffsperrschicht nach dem Abziehen des Schichtträgers dienen.

Ebenso kann auf der dem Träger abgewandten Oberfläche der photopolymerisierbaren Aufzeichnungsschicht auch noch eine Deckschicht oder Deckfolie angeordnet sein, die vorzugsweise in dem gleichen Entwickler-Lösungsmittel löslich ist wie die photopolymerisierbare Aufzeichnungsschicht, oder von dieser abziehbar ist. Diese Deckschicht bzw. Deckfolie dient vor allem dem Schutz der photopolymerisierbaren Aufzeichnungsschicht bei der Lagerung und Handhabung der lichtempfindlichen Aufzeichnungselemente und gegebenenfalls auch als Sauerstoffsperre für die photopolymerisierbare Aufzeichnungsschicht. Als besonders geeignet haben sich z.B. Deckschichten aus Polyvinylalkoholen oder Polyvinylalkohol-Derivaten bzw. - insbesondere bei Photoresistfilmen - Deckfolien aus Polyolefinen, wie z.B. Polyethylen oder Polypropylen, erwiesen.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mi schung auf den - gegebenenfalls mit einer Zwischenschicht versehenen -Träger erfolgen. Beispielsweise kann man die Komponenten der photopolymerisierbaren Aufzeichnungsschicht rein mechanisch in einer geeigneten Mischvorrichtung, z.B. einem Mischer oder Extruder, homogen vermischen und diese Mischung, beispielsweise durch Extrudieren, Kalandrieren oder Pressen, zu einer Schicht der gewünschten Dicke formen, die dann auf den Träger auflaminiert bzw. aufkaschiert wird. Vorteilhafterweise werden die lichtempfindlichen Aufzeichnungselemente jedoch hergestellt, indem man die Komponenten der photopolymerisierbaren Aufzeichnungsschicht in einem geeigneten Lösungsmittel oder Lösungsmittelgemisch löst und diese Lösung durch Gießen, Tauchen, Sprühen oder andere bekannte Auftragstechniken in der gewünschten Schichtstärke auf den Träger aufbringt. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, Ethylacetat und ähnliche, sowie Mischungen hiervon. Anschließend kann auf die photopolymerisierbare Aufzeichnungsschicht gewünschtenfalls noch die Deckschicht oder Deckfolie aufgebracht werden.

Die erfindungsgemäßen lichtempfindlichen Aufzeichnungselemente eignen sich in vorteilhafter Weise für die Herstellung von Druckformen oder Resistmustern nach den hierfür an sich bekannten und üblichen Verfahren. Hierzu wird die photopolymerisierbare Aufzeichnungsschicht - bei Photoresistfilmen und Schichtübertragungsmaterialien nach der Schichtübertragung auf das zu schützende Substrat - bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel-oder -niederdruckstrahler, superaktinische Leuchtstoffröhren, Xenon-Impulslampen, aber auch UV-Laser, Argonlaser und ähnliche, eignen. Die von den Lichtquellen emittierte Wellenlänge soll im allgemeinen zwischen 230 und 450 nm, bevorzugt zwischen 300 und 420 nm, liegen und insbesondere auf die Eigenabsorption des in der photopolymerisierbaren Aufzeichnungsschicht enthaltenen Photoinitiators abgestimmt sein.

Durch die bildmäßige Belichtung mit dem aktinischen Licht wird in den belichteten Bereichen der Aufzeichnungsschicht eine Photopolymerisation ausgelöst, die zu einer Vernetzung in den belichteten Schichtbereichen und damit zu einer Löslichkeitsdifferenzierung zwischen den belichteten und unbelichteten Schichtbereichen führt. Nach der bildmäßigen Belichtung wird die Druckform bzw. das Resistmuster durch Auswaschen der unbelichteten, unvernetzten Bereiche der Aufzeichnungsschicht mit einer wäßrig-alkalischen Entwicklerlösung entwickelt. Das Entwickeln kann durch Waschen, Sprühen, Reiben, Bürsten etc. erfolgen. Die erfindungsgemäßen Aufzeichnungselemente zeigen dabei einen großen Entwicklungsspielraum und eine sehr geringe Überwaschempfindlichkeit. Als Entwicklerlösungen kommen wäßrig-alkalische Lösungen in Betracht, die zur Einstellung des günstigsten pH-Wertes, im allgemeinen im Bereich von 8 bis 14, vorzugsweise im Bereich von etwa 9 bis 13, alkalisch reagierende Substanzen, wie z.B. Borax, Dinatriumhydrogenphosphat, Soda, Alkalihydroxide oder organische Basen, wie Di-oder Triethanolamin in Wasser gelöst, enthalten. Die wäßrig-alkalischen Entwicklerlösungen können auch Puffersalze, z.B. wasserlösliche Alkaliphosphate, -silikate, -borate, -acetate oder -benzoate enthalten. Als weitere Bestandteile der Entwicklerlösungen können Netzmittel, vorzugsweise anionische Netzmittel, und gegebenenfalls wasserlösliche Polymere, wie z.B. Natriumcarboxymethylcellulose, Polyvinylalkohol, Polynatriumacrylat und dergleichen, mitverwendet werden. Obwohl die erfindungsgemäßen Aufzeichnungselemente im allgemeinen mit rein wäßrig-alkalischen Entwicklerlösungen ausgewaschen werden, ist es selbstverständlich grundsätzlich möglich, wenn auch nicht erforderlich, daß die wäßrig-alkalischen Entwicklerlösungen auch noch geringe Zusätze an wasserlöslichen organischen Lösungsmitteln, wie z.B. aliphatischen Alkoholen, Aceton oder Tetrahydrofuran, enthalten.

Die erfindungsgemäßen lichtempfindlichen Aufzeichnungselemente zeichnen sich durch ihre guten Belichtungseigenschaften und gute Entwickelbarkeit in wäßrig-alkalischen Entwicklerlösungen aus, wodurch es möglich ist, auch sehr feine Bildelemente vorlagengetreu und sicher zu reproduzieren. Auf metallischen oder metalloxidischen Untergründen besitzen die erfindungsgemäßen photopolymerisierbaren Aufzeichnungsschichten eine hervorragende Haftung, ohne daß es bei der Entwicklung der bildmäßig belichteten Aufzeichnungsschicht zur Ausbildung von Restschicht-Belägen in den ausgewaschenen Bereichen kommt. Ferner besitzen die Aufzeichnungselemente im belichteten, d.h. photovernetzten Zustand, eine sehr hohe Beständigkeit gegenüber wäßrigen Medien, wie sie beispielsweise bei der Verwendung von Druckformen oder Resistmustern zur Anwendung kommen. Die erfindungsgemäßen lichtempfindlichen Aufzeichnungsmaterialien eignen sich grundsätzlich für alle Anwendungsgebiete der Reprographie und optischen Informationsfixierung.

Die Erfindung wird durch die nachfolgenden Beispiele näher erläutert. Die in den Beispielen genannten Teile und Prozente beziehen sich, sofern nicht anders angegeben, auf das Gewicht.

Beispiel 1

Aus folgenden Komponenten wurde eine homogene Lösung hergestellt:

20 % eines Copolymerisats aus 64 % Methylmethacrylat, 24 % N-Vinylpyrrolidon, 10 % Methacrylsäure und 2 % Dimethylaminoethylmethacrylat (30 %ig in Methanol);
K-Wert nach Fikentscher: 37
48,4 % eines Oligomeren aus Bisphenol-A-diglycidylether, Phthalsäureanhydrid und Acrylsäure, SZ 90 mg KOH/g (52 %ig in Essigester)
12,5 % Trimethylolpropantriacrylat,
12,5 % eines Umsetzungsproduktes aus Butandioldiglycidylether mit Methacrylsäure
2,5 % 2,5-Dichlor-1,4-bis[dichlormethyl]benzol
3 % Benzophenon
0,6 % Kristallviolett-Leukobase
0,15 % Michler's Keton
0,1 % 2,6-Di-tert.-4-methylphenol
0,2 % p-Aminobenzoesäure
0,08 % Flexoblau 810

Die filtrierte Lösung wurde zu einer 38µm dicken Resistschicht gegossen und in einem dafür üblichen Trockenkanal mit einer Geschwindigkeit von 9 m pro Minute getrocknet. Es resultiert eine elastische Folie, die beim Schneiden keine Flitterbildung zeigt und auf der Rolle keinen plastischen Fluß zeigt.

Beispiel 2

Wie in Beispiel 1 wird eine Lösung hergestellt aus:

21 % des Copolymeren aus Beispiel 1
46,37 % des Oligomeren aus Beispiel 1
12 % des Umsetzungsproduktes aus Butandioldiglycidylether mit Methacrylsäure
12 % Trimethylolpropantriacrylat,

2,5 % 2,5-Dichlor-1,4-bis[dichlormethyl]benzol
2 % Dibutylphthalat
0,6 % Kristallviolett-Leukobase
0,15 % Michler's Keton
0,1 % 2,6-Di-tert.-4-methylphenol
0,2 % p-Aminobenzoesäure
0,08 % Flexoblau 810

Man stellt eine Schicht wie in Beispiel 1 beschrieben her. Es resultiert eine elastische Schicht ohne kalten Fluß, die beim Schneiden nicht splittert.

Vergleichsbeispiel 1

Man stellt eine Lösung her wie in Beispiel 1 beschrieben, verwendet statt des Basispolymeren aber eines folgender Zusammensetzung:

67,5 % Methylmethacrylat
22,5 % N-Vinylpyrrolidon
10 % Methacrylsäure
K-Wert (nach Fikentscher): 37

Beim Versuch, eine Schicht aus dieser Lösung zu gießen, tritt eine Entmischung auf und man erhält keinen transparenten homogenen Film.

Vergleichsbeispiel 2

Man stellt eine Lösung her wie in Beispiel 1 beschrieben, aber mit dem Basispolymeren folgender Zusammensetzung:

67,5 % Methylmethacrylat
22,5 % N-Vinylpyrrolidon
10 % Methacrylsäure
K-Wert: 23,2

Diese Lösung wird zu einer Schicht gegossen und im Trockenkanal mit 9 m pro Minute getrocknet. Man erhält einen homogenen aber klebrigen Film, der auf der Rolle starken plastischen Fluß zeigt.

Vergleichsbeispiel 3

Man stellt eine Schicht wie in Vergleichsbeispiel 2 her, trocknet aber den Film mit 4 m pro Minute. Man erhält einen Resistfilm mit nur wenig kaltem Fluß. Dieser Film zeigt aber eine hohe Sprödigkeit und weist beim Schneiden starke Flitterbildung auf.

## Ansprüche

1. Lichtempfindliches, zur Herstellung von Druckformen oder Resistmustern geeignetes Aufzeichnungselement mit einer auf einem dimensionsstabilen Träger aufgebrachten, wäßrig-alkalisch entwickelbaren, ein polymeres Bindemittel enthaltenden, photopolymerisierbaren Aufzeichnungsschicht, dadurch gekennzeichnet, daß in der photopolymerisierbaren Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat aus 10 bis 50 Gew.% mindestens eines N-Vinylamids, 5 bis 30 Gew.% Acrylsäure und/oder Methacrylsäure, 30 bis 80 Gew.% mindestens eines Comonomeren aus der Gruppe der Vinylaromaten und Ester der Acrylsäure oder Methacrylsäure mit 1 bis 8 Kohlenstoffatome enthaltenden Monoalkanolen und 0,2 bis 5 Gew.% mindestens einer copolymerisierbaren, stickstoffbasischen, olefinisch ungesättigten organischen Verbindung mit einem $pK_a$-Wert > 4 enthalten ist.

2. Lichtempfindliches Aufzeichnungselement nach Anspruch 1, dadurch gekennzeichnet, daß das in der photopolymerisierbaren Aufzeichnungsschicht als polymeres Bindemittel enthaltene Copolymerisat als copolymerisierbare, stickstoffbasische, olefinisch ungesättigte organische Verbindung mit einem $pK_a$-Wert > 4 mindestens eine Verbindung der allgemeinen Formeln

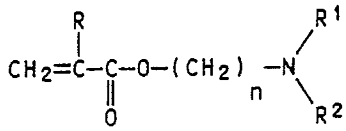

(I)

und/oder

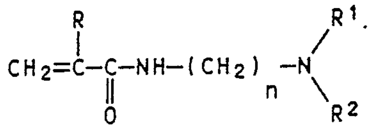

(II)

einpolymerisiert enthält, worin n = 2 bis 6, R für Wasserstoff oder eine Methylgruppe steht, $R^1$ und $R^2$ untereinander gleich oder verschieden sind und für Wasserstoff, einen geradkettigen oder verzweigten Alkylrest mit 1 bis 6 Kohlenstoffatomen, einen geradkettigen oder verzweigten Hydroxyalkylrest mit 1 bis 6 Kohlenstoffatomen, einen geradkettigen oder verzweigten Hydroxyalkylrest mit 1 bis 6 Kohlen stoffatomen, dessen Hydroxygruppen mit 1 bis 4 Kohlenstoffatome enthaltenden Alkanolen verethert sind, einen Cycloalkylrest mit 5 oder 6 Kohlenstoffatomen stehen oder die Reste $R^1$ und $R^2$ zusammen einen fünf-oder sechsgliedrigen Ring bilden, der gegebenenfalls ein weiteres Heteroatom enthält.

3. Lichtempfindliches Aufzeichnungselement nach Anspruch 1, dadurch gekennzeichnet, daß das in der photopolymerisierbaren Aufzeichnungsschicht als polymeres Bindemittel enthaltene Copolymerisat als copolymerisierbare, stickstoffbasische, olefinisch ungesättigte organische Verbindung mit einem $pK_a$-Wert > 4 N-Vinylimidazol oder 2-Methyl-1-vinylimidazol einpolymerisiert enthält.

4. Aufzeichnungselement nach Anspruch 2, dadurch gekennzeichnet, daß die in der photopolymerisierbaren Aufzeichnungsschicht als polymeres Bindemittel enthaltenen Copolymerisate als Verbindungen der allgemeinen Formeln (I) und/oder (II) Dialkylaminoalkylmethacrylate oder Dialkylaminoalkylmethacrylamide einpolymerisiert enthalten, worin n = 2 bis 6 und $R^1$ und $R^2$ geradkettige Alkylreste mit 1 bis 4 Kohlenstoffatomen bedeuten.

5. Aufzeichnungselement nach Anspruch 2 oder 4, dadurch gekennzeichnet, daß die in der photopolymerisierbaren Aufzeichnungsschicht als polymeres Bindemittel enthaltenen Copolymerisate als Verbindungen der allgemeinen Formeln (I) und/oder (II) mindestens eine Verbindung aus der Gruppe Dimethylaminoethylacrylat, Dimethylaminoethylmethacrylat, Diethylaminoethylacrylat, Diethylaminoethylmethacrylat, Dimethylaminoethylacrylamid, Dimethylaminoethylmethacrylamid, Diethylaminoethylacrylamid und Diethylaminoethylmethacrylamid einpolymerisiert enthalten.

6. Lichtempfindliches Aufzeichnungselement nach einem der Ansprüche 1 bis 5, dadurch gekennzeichnet, daß die in der photopolymerisierbaren Aufzeichnungsschicht als polymeres Bindemittel enthaltenen Copolymerisate als N-Vinylamid-Comonomere mindestens ein N-Vinyllactam, insbesondere N-Vinylpyrrolidon und/oder N-Vinylcaprolactam, einpolymerisiert enthalten.

7. Lichtempfindliches Aufzeichnungselement nach einem der Ansprüche 1, 2 oder 4 bis 6, dadurch gekennzeichnet, daß in der photopolymerisierbaren Aufzeichnungsschicht als polymeres Bindemittel ein N-Vinyllactam/(Meth)acrylsäure/Methylmethacrylat/Dimethylaminoethyl(meth)acrylat-Copolymerisat enthalten ist.

8. Lichtempfindliches Aufzeichnungselement nach einem der Ansprüche 1, 2 oder 4 bis 6, dadurch gekennzeichnet, daß in der photopolymerisierbaren Aufzeichnungsschicht als polymeres Bindemittel ein N-Vinyllactam/(Meth)acrylsäure/Styrol/Dimethylaminoethyl(meth)acrylat-Copolymerisat enthalten ist.

9. Lichtempfindliches Aufzeichnungselement nach einem der vorhergehenden Ansprüche, dadurch gekennzeichnet, daß die photopolymerisierbare Aufzeichnungsschicht neben dem polymeren Bindemittel mindestens eine ethylenisch ungesättigte, photopolymerisierbare Verbindung, mindestens einen Photoinitiator sowie gegebenenfalls weitere Zusatz-und/oder Hilfsstoffe enthält.

10. Lichtempfindliches Aufzeichnungselement nach Anspruch 9, dadurch gekennzeichnet, daß die photopolymerisierbare Aufzeichnungsschicht als ethylenisch ungesättigte, photopolymerisierbare Verbindungen Monomere und/oder Oligomere mit zwei oder mehr Acryloyl-und/oder Methacryloyl-Gruppen enthält.

11. Lichtempfindliches Aufzeichnungselement nach Anspruch 9 oder 10, dadurch gekennzeichnet, daß die photopolymerisierbare Aufzeichnungsschicht die polymeren Bindemittel und die ethylenisch ungesättigten, photopolymerisierbaren Verbindungen im Gewichtsverhältnis von 1:99 bis 90:10 enthält.

Patentansprüche für folgende Vertragsstaaten: AT, ES

1. Verfahren zur Herstellung eines lichtempfindlichen, zur herstellung von Druckformen oder Reisstimustern geeigneten Aufzeichnungselements mit einer auf einem dimensionsstabilen Träger aufgebrachten, wäßrig-alkalisch entwickelbaren, ein polymers Bindemittel enthaltenden, photopolymerisierbaren Aufzeichnungsschict, dadurch gekennzeichnet, daß in der photopolymerisierbaren Aufzeichnungsschicht als polymeres Bindemittel mindestens ein in Wasser unlösliches, in wäßrig-alkalischen Lösungen jedoch lösliches oder zumindest dispergierbares, filmbildendes Copolymerisat aus 10 bis 50 Gew.% mindestens eines N-Vinylamids, 5 bis 30 Gew.% Acrylsäure und/oder Methacrylsäure, 30 bis 80 Gew.% mindestens eines Comonomeren aus der Grupe der Vinylaromaten und Ester der Acrylsäure oder Methacrylsäure mit 1 bis 8 Kohlenstoffatome enthaltenden Monoalkanolen und 0,2 bis 5 Gew.% mindestens einer copolymerisierbaren, stickstoffbasischen, olefinisch ungesättigten organischen Verbindung mit einem $pK_a$-Wert > 4 eingesetzt wird.

2. Verfahren nach Anspruch 1, dadurch gekennzeichnet, daß zur Herstellung des in der photopolymerisierbaren Aufzeichnungsschicht als polymeres Bindemittel enthaltenen Copolymerisats als copolymerisierbare, stickstoffbasische, olefinisch ungesättigte organische Verbindung mit einem $pK_a$-Wert > 4 mindestens eine Verbindung der allgemeinen Formeln

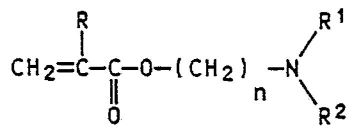 (I)

und/oder

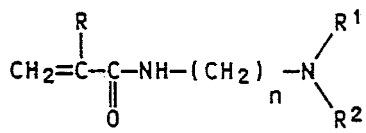 (II)

einpolymerisiert wird, worin n = 2 bis 6, R für Wasserstoff oder eine Methylgruppe steht, $R^1$ und $R^2$ untereinander gleich oder verschieden sind und für Wasserstoff, einen geradkettigen oder verzweigten Alkylrest mit 1 bis 6 Kohlenstoffatomen, einen geradkettigen oder verzweigten Hydroxyalkylrest mit 1 bis 6 Kohlenstoffatomen, einen geradkettigen oder verzweigten Hydroxyalkylrest mit 1 bis 6 Kohlen stoffatomen, dessen Hydroxygruppen mit 1 bis 4 Kohlenstoffatome enthaltenden Alkanolen verethert sind, einen Cycloalkylrest mit 5 oder 6 Kohlenstoffatomen stehen ode die Reste $R^1$ und $R^2$ zusammen einen fünf-oder sechsgliedrigen Ring bilden, der gegebenenfalls ein weiteres Heteroatom enthält.

3. Verfahren nach Anspruch 1, dadurch gekennzeichent, daß zur Herstellung des in der photopolymerisierbaren Aufzeichnungsschicht als polymeres Bindemittel enthaltenen Copolymerisats als copolymerisierbare, stickstoffbasische, olefinisch ungesättigte organische Verbindung mit einem $pK_a$-Wert > 4 N-Vinylimidazol oder 2-Methyl-1-vinylimidazol einpolymerisiert wird.

4. Verfahren nach Anspruch 2, dadurch gekennzeichnet, daß zur Herstellung der in der photopolymerisierbaren Aufzeichnungsschicht als polymeres bindemittel enthaltenen Copolymerisate als Verbindungen der allgemeinen Formeln (I) und/oder (II) Dialkylaminoallkylmethacrylate oder Dialkylaminoalkylmethacrylamide einpolymerisiert werden, worin n = 2 bis 6 und $R^1$ und $R^2$ geradkettige Alkylreste mit 1 bis 4 Kohlenstoffatomen bedeuten.

5. Verfahren nach Anspruch 2 oder 4, dadurch gekennzeichnet, daß zur Herstellung der in der photopolymerisierbaren Aufzeichnungsschicht als polymeres Bindemittel enthaltenen Copolymerisate als Verbindungen der allgemeinen Formeln (I) und/oder (II) mindestens eine Verbindung aus der Gruppe Dimethylaminoethylacrylat, Dimethylaminoethylmethacrylat, Diethylaminoethylacrylat, Diethylaminoethylmethacrylat, Dimethylaminoethylacrylamid, Dimethylaminoethylmethacrylamid, Diethylaminoethylacrylamid und Diethylaminoethylmethacrylamid einpolymerisiert wird.

6. Verfahren nach einem der Ansprüche 1 bis 5, dadurch gekennzeichnet , daß zur herstellung der in der photopolymerisierbaren Aufzeichnungsschicht als polymeres Bindemittel enthaltenen Copolymerisate als N-Vinylamid-Comonomere mindestens ein N-Vinyllactam, insbesondere N-Vinylpyrrolidon und/oder N-Vinylcaprolactam, einpolymerisiert werden.

7. Verfahren nach einem der Ansprüche 1, 2 oder 4 bis 6, dadurch gekennzeichnet, daß in der photopolymerisierbaren Aufzeichnungsschicht als polymeres Bindemittel ein N-Vinyllactam/(Meth)-acrylsäure/Methylmethacrylat/Dimethylaminoethyl(meth)acrylat-Copolymerisat eingesetzt wird.

8. Verfahren nach einem der Ansprüche 1, 2 oder 4 bis 6, dadurch gekennzeichent, daß in der photopolymerisierbaren Aufzeichnungsschicht als polymeres Bindemittel ein N-Vinyllactam/(Meth)-acrylsäure/Styrol/Dimethylaminoethyl(meth)acrylat-Copolymerisat eingesetzt wird.

9. Verfahren anch einem der vorhergehenden Ansprüche, dadurch gekennzeichnet, daß die photopolymerisierbare Aufzeichnungsschicht neben dem polymeren Bindemittel mindestens eine ethylenisch ungesättigte, photopolymerisierbare Verbindung, mindestens einen Photoinitiator sowie gegebenenfalls weitere Zusatz-und/oder Hilfsstoffe eingesetzt werden.

10. Verfahren nach Anspruch 9, dadurch gekennzeichnet,, daß zur Herstellung der photopolymerisierbaren Aufzeichnungsschicht als ethylenish ungesättigte, photopolymerisierbare Verbindungen Monomere und/oder Oligomere mit zwei oder mehr Acryloyl-und/oder Methacryloyl-Gruppen eingesetzt werden.

11. Verfahren nach Anspruch 9 oder 10, dadurch gekennzeichnet, daß zur Herstellung der photopolymerisierbaren Aufzeichnungsschicht die polymeren Bindemittel und die ethylenisch ungesättigten, photopolymerisierbaren Verbindungen im Gewichtsverhältnis von 1:99 bis 90:10 eingesetzt werden.